# EUROPÄISCHE PATENTSCHRIFT

(11) **EP 0 804 637 B1**
(45) Veröffentlichungstag und Bekanntmachung des Hinweises auf die Patenterteilung: **04.11.1998**
(21) Anmeldenummer: 96902242.5
(22) Anmeldetag: 12.02.1996
(51) Int. Cl.: C25D 17/06, H05K 3/24

(54) **VERFAHREN UND VORRICHTUNG ZUM GALVANISIEREN VON PLATTENFÖRMIGEM BEHANDLUNGSGUT IN HORIZONTALEN DURCHLAUFANLAGEN**
METHOD AND DEVICE FOR GALVANIZING PLATE-SHAPED PRODUCTS IN HORIZONTAL CONTINUOUS PLANTS
PROCEDE ET DISPOSITIF POUR GALVANISER DES PRODUITS SE PRESENTANT SOUS FORME DE PLAQUES DANS DES INSTALLATIONS HORIZONTALES A PASSAGE CONTINU

(30) Priorität: 11.02.1995 DE 19504517
(43) Veröffentlichungstag der Anmeldung: 05.11.1997
(73) Patentinhaber: ATOTECH Deutschland GmbH, 10553 Berlin (DE)
(72) Erfinder: KOPP, Lorenz, D-90518 Altdorf (DE); SCHARRER, Helmut, D-90559 Burgthann (DE)
(74) Vertreter: Effert, Bressel und Kollegen
(86) Internationale Anmeldenummer: DE9600261
(87) Internationale Veröffentlichungsnummer: WO9624707

(56) Entgegenhaltungen:
- EP-A- 0 517 349
- DE-U- 9 102 321

## Beschreibung

Die Erfindung betrifft ein Verfahren und eine Vorrichtung zum Galvanisieren von plattenförmigem Behandlungsgut in horizontalen Durchlaufanlagen, insbesondere zur elektrolytischen Behandlung von Leiterplatten und Leiterfolien.

In der europäischen Patentschrift 0254030 B1 wird eine derartige Anordnung beschrieben. Das Behandlungsgut wird horizontal durch die Galvanoanlage transportiert. Entlang der Transportbahn befinden sich die Anoden in Form von Platten oder Körben, die mit dem abzuscheidenden Metall befüllt sind. Mit diesem Metall wird das Behandlungsgut während des Durchlaufes durch die Galvanoanlage in bekannter Art und Weise beschichtet.
Transportorgane in Form von Klammern ergreifen beim Einlaufen in die Galvanoanlage das plattenförmige Behandlungsgut an dessen Rand. Am Ende der Elektrolysekammer geben die Klammern das Behandlungsgut wieder frei. Die an einem endlos umlaufenden Transportmittel befestigten Klammern werden zum Einlauf der Galvanoanlage zurückgefördert.
Außer zum Transport dienen die Klammern auch zur kathodischen Kontaktierung des Behandlungsgutes während des horizontalen Durchlaufes durch die Galvanoanlage. Deshalb bestehen die Klammern aus einem elektrisch leitfähigen Werkstoff. Ferner ist jede Klammer außerhalb der Elektrolysezelle, d. h. oberhalb des Badspiegels, zur Übertragung des Galvanisierstromes mit einer Bürstenanordnung versehen.

Durch die kathodische Polarität der Klammer wird sie innerhalb der Elektrolysezelle ebenso wie das Behandlungsgut mit dem abzuscheidenden Metall beschichtet. Zur Vermeidung einer fortgesetzten Beschichtung je Umlauf werden die Klammern während des Rücklaufes in einer Entmetallisierungskammer wieder entmetallisiert. Die Entmetallisierungskammer kann aus anlagentechnischen Gründen nur den Elektrolyt enthalten, der sich auch in der Elektrolysezelle befindet. Für die Metallisierung ist der Elektrolyt optimiert, nicht jedoch für die Entmetallisierung. Der massive Metallauftrag wird häufig durch elektrolytische Entmetallisierung nicht vollständig entfernt. Bei der Leiterplattenfertigung erweist es sich auch als Nachteil, daß die elektrisch sehr gut leitenden und kathodisch gepolten Klammern als "Raubkathode" wirken. Die Folge davon ist, daß die abgeschiedene Schicht auf der Leiterplatte in der Nähe der Klammern zu gering ist. Aus der unerwünschten Metallabscheidung ergibt sich ein zusätzlicher Anodenverbrauch und zusätzlicher Energieverbrauch, insbesondere zum Entmetallisieren.

In der DE 42 12 567 A1 wird eine weitere horizontale Durchlaufanlage zum Galvanisieren von Leiterplatten beschrieben. Als Kontaktiermittel dienen hier Stangen mit Greifern, die die Platten nicht seitlich, sondern an der Vorderkante fassen und durch die Anlage ziehen. Die Stangen sind ebenfalls kathodisch gepolt. Infolgedessen werden sie ebenso wie das Behandlungsgut galvanisiert. Auch hier erfolgt die Entmetallisierung während des Rücklaufs der Stangen zum Ausgangspunkt hin. Die genannten Nachteile treffen auch für dieses Kontaktiermittel zu.

Zur Vermeidung der genannten Nachteile werden nach dem Stand der Technik die Klammern bzw. Stangen mit einem elektrisch isolierenden Werkstoff überzogen. Der Überzug erfaßt mindestens den Bereich der Klammern bzw. der Stangen, der in die Elektrolysezelle hineinragt. Nur der Bereich des eigentlichen Kontaktes zum Behandlungsgut, z.B. einer Leiterplatte, bleibt ohne Isolierung. Als Isolierwerkstoffe kommen die bei galvanotechnischen Gestellen bekannten Werkstoffe wie PTFE in Frage; geeignet sind auch Glas, Keramik und Email.

In der Praxis zeigt es sich nun, daß trotz der elektrischen Isolation auf den Klammern bzw. Stangen partiell elektrolytisch Metall abgeschieden wird. Ursachen hierfür sind Störstellen in der Isolierschicht, Beschädigungen in dieser Schicht während des Gebrauches und der notwendigerweise metallisch blanke Kontakt. An diesen Stellen sind die Felddichten so konzentriert, daß eine überproportionale Metallisierung erfolgt. Diese ist dann in der anschließenden Entmetallisierung nicht vollständig abtragbar, selbst wenn versucht wird, hier mit einer hohen Stromdichte zu arbeiten. Bei zu hoher Stromdichte brennt die elektrisch leitende Verbindung von der abzutragenden Schicht zur Klammer bzw. Stange durch, d. h. die unerwünschten Abscheidungen auf der Isolierschicht stellen eine elektrolytisch nicht mehr zu entfernende metallische Insel dar, weil sie nur noch eine hochohmige Verbindung zum metallischen Grundkörper hat. Diese Verbindung bewirkt jedoch, daß bei jedem Durchlauf durch die Elektrolysezelle ein Wachstum der Insel zu beobachten ist. Trotz der Isolierschicht auf den Kontaktiermitteln und der Entmetallisierung nach jedem Metallisieren führt dies dazu, daß die Kontaktiermittel wegen massiver Metallabscheidungen von Zeit zu Zeit ausgetauscht werden müssen. Weil diese Abstände in der Größenordnung von wenigen Wochen liegen, bedeutet dies neben den hohen Kosten für Arbeitszeit und Ersatzmaterial auch Produktionsausfall.

In der Praxis kommt es vor, daß die Galvanisieranlage nicht permanent mit Behandlungsgut beschickt wird. Die Anlage wird oft in Betrieb genommen und nach Produktionsende wieder stillgelegt. In diesen Fällen muß der endlose Transport der Kontaktiermittel mindestens so lange weiterlaufen, bis die letzte Platte die Anlage verlassen hat. Streckenweise oder zeitweise befinden sich daher nur noch Kontaktiermittel aber kein Behandlungsgut in der Anlage. Die Kontaktiermittel, die eine ideale kathodische Kontaktierung haben, galvanisieren dann an allen metallischen, offenen Stellen infolge der elektrischen Spitzenwirkung besonders intensiv. Nicht selten führt dies zu Anbrennungen der abgeschiedenen Metallschichten, insbesondere um den eigentlichen Kontaktpunkt herum, der in diesem Falle kein Behandlungsgut greift. Die Anbrennungen verunreinigen den Elektrolyt durch kleinste Metallpartikel. Die Partikel sind nur sehr aufwendig auszufiltern. Partikel im Elektrolyten bilden Pickel in der elektrolytischen Schicht des Behandlungsgutes.

Zur Vermeidung von Anbrennungen bzw. von zu starken Abscheidungen auf dem Behandlungsgut und an den Kontaktiermitteln ist ein Verfahren aus der DE 30 39 681 C2 bekannt. Mit Rücksicht auf die Lage des Behandlungsgutes unter bzw. über den Anoden werden diese mittels elektromagnetischer Hochstromschaltgeräte zugeschaltet oder abgeschaltet, so daß unzulässig hohe Feldliniendichten am Behandlungsgut bei größeren Lücken in der Behandlungsgutfolge vermieden werden. Befindet sich kein Behandlungsgut im Bereich der Anode, so wird sie abgeschaltet. Die dort zufällig anwesenden Kontaktiermittel sind dann auch keiner Feldlinienkonzentration ausgesetzt. Diese wirkungsvolle, aber auch technisch aufwendige Maßnahme hat in Bezug zu Galvanisieranlagen mit Klammerorganen immer noch einen Nachteil: Leiterplatten beispielsweise, durchfahren derartige Horizontalanlagen in einem Abstand von ca. 20 Millimetern. Die Plattenlängen sind in der Praxis unterschiedlich. Eine Synchronisation der Lage der umlaufenden Klammern mit der Lage der Leiterplatten, die zu beliebigen Zeitpunkten in die Anlage eingefahren werden, ist ohne Nachteil für eine homogene Schichtdickenverteilung des abgeschiedenen Metalles nicht möglich. Dies führt dazu, daß sporadisch Klammern in eine derartige Lücke zwischen den Werkstücken greifen. Sie sind kathodisch gepolt und befinden sich im Wirkbereich der eingeschalteten Anoden. Störstellen in der Isolierschicht der Klammern und die Kontakte werden dann besonders intensiv galvanisiert, was trotz aller Gegenmaßnahmen zu den beschriebenen Nachteilen führt.

Die Übertragung des Kathodenpotentiales der stationären Badstromquellen an die umlaufenden Klammern erfolgt mittels Schleifbürsten. Entlang der horizontalen Galvanoanlage befindet sich parallel zur Bahn der umlaufenden Klammern eine langgestreckte Schleifschiene. Jede Klammer hat eine Schleifbürste, die auch als Schleifkontakt bezeichnet wird. Die Schleifbürste stellt die elektrische Verbindung von der stationären Schleifschiene zur umlaufenden Klammer her. An den Umkehrpunkten des die Klammern transportierenden Bandes wird die Kontaktierung nicht benötigt. Deshalb endet die Schleifschiene vor der Umkehrung. Zur Entmetallisierung werden die Klammern während des Rücklaufes über eine zweite Schleifschiene kontaktiert. In diesem Falle erhalten die Klammern Anodenpotential von einer weiteren Badstromquelle. Vor dem zweiten Umkehrpunkt endet diese Schleifschiene. Danach werden die Klammern wieder an die beschriebene Schiene mit dem Kathodenpotential zur Metallisierung gekoppelt. Während eines vollständigen Umlaufes einer Klammer läuft die Schleifbürste somit zweimal auf eine Schleifschiene auf und wieder herunter. In dieser Weise wird die elektrische Badstromversorgung sichergestellt. Zusätzlich muß jede Klammer nach dem Umkehrpunkt am Ende der Einlaufstrecke das einlaufende Behandlungsgut durch Schließen der Klammer ergreifen. Vor Beginn des Auslaufumkehrpunktes muß die Klammer durch Öffnen das Gut wieder freigeben. Diese Schließ- und Öffnungsbewegungen werden durch stationäre schiefe Ebenen an den Umkehrpunkten, über die entsprechend geformten Nocken der Klammern zwangsgeführt werden, erzwungen. Dies bedeutet, daß das Schließen und Öffnen vom Antrieb der umlaufenden Klammern mit bewirkt wird. Die Schließkraft selbst erzeugt eine Feder in der Klammer. In bekannten horizontalen Durchlaufanlagen sind an einem umlaufenden Band, z. B. an einem Zahnriemen, ca. 160 Klammern im Abstand von jeweils 80 Millimetern befestigt. Die Zwangsführung ist unabhängig davon, ob sich im Bereich der Klammer Behandlungsgut befindet oder nicht, das heißt, ob das Klammerschließen sowie die elektrische Kontaktierung benötigt wird oder nicht. Folge dieser zwangsgeführten Anordnung sind die beschriebenen Verfahrensnachteile.

In der GB-A- 22 66 727 wird ein System zum kontinuierlichen Galvanisieren von Leiterplatten offenbart. Ein Behandlungsgut wird in gleichbleibender Folge fortlaufend elektrisch kontaktiert. Ein gesteuertes Zu- und Abschalten der Kontaktiermittel in Abhängigkeit von Behandlungsgutlücken ist nicht vorgesehen.

In DE-B- 25 12 762 ist eine Tauchbad-Galvanisieranlage bekannt, bei der Behandlungsgut an einer umlaufenden Kette befestigt ist. An bestimmten Umlaufstellen im Bereich des elektrolytischen Bades wird der Werkstückträger kontaktiert, unabhängig davon, ob sich am Werkstückträger Behandlungsgut befindet oder nicht. Beim Einlauf des elektrolytischen Bades wird kein Werkstück individuell ergriffen, sondern ist am Werkstückträger (Kontaktiermittel) befestigt und durchläuft so die gesamte Anlage mit einer Vielzahl von Behandlungsstationen, ohne zwischendurch von der Kette abgenommen zu werden.

Zum Schutz der Kontaktiermittel gegen unzulässiges Galvanisieren am Kontakt ist eine in der DE 39 39 256 C2 beschriebene Einrichtung bekannt. Befindet sich keine Leiterplatte im Kontaktbereich, so wird das Kontaktiermittel derart geschlossen, daß der Kontakt mit Hilfe eines Dichtungselementes elektrisch völlig isoliert ist. In der Praxis haben die Leiterplatten unterschiedliche Längen. Die Kontaktiermittel sind nicht mit dem Leiterplattentransport synchronisiert. Infolgedessen ergreifen die Kontaktiermittel auch ab und zu nur teilweise den Rand der Leiterplatte. Somit wird die Wirkung des Dichtelementes aufgehoben. Der Kontakt galvanisiert zumindest partiell. Des weiteren kommt es vor, daß das Kontaktiermittel so ungünstig an der Kante einer Leiterplatte greift, daß das Dichtelement und/oder die Isolierschichten im Kontaktbereich zerstört werden. Die glasfaserverstärkten Leiterplatten sind an ihren Schnittkanten sehr rauh und zusammen mit der großen Kontaktkraft zerstören sie die daran anliegenden Isoliermittel.

Der Erfindung liegt von daher das Problem zugrunde, ein Verfahren und eine Vorrichtung anzugeben, die es ermöglichen, Behandlungsgut in beliebig unterbrochener Folge durch eine elektrolytische horizontale Durchlaufanlage so zu transportieren und dabei die beschriebenen Nachteile zu vermeiden, insbesondere die Kontaktiermittel nicht zu metallisieren.

Gelöst wird das Problem durch die Merkmale der Ansprüche 1 und 8, vorteilhafte Weiterbildungen der Erfindung sind in den Unteransprüchen erfaßt.

Durch das gezielte Zu- und Abschalten jedes einzelnen, an einem Transportband befestigten und endlos umlaufenden Kontaktiermittels an das Kathodenpotential der Badstromversorgung in Abhängigkeit von der Position des Behandlungsgutes im Bereich der greifenden Kontakte dieser Mittel wird die unerwünschte Metallisierung vermieden. Die Position des Behandlungsgutes wird vor dem Einlauf in die Galvanoanlage mit einem Sensor detektiert. Ein Steuerungssystem verfolgt das Gut logisch bis zu dem Greifpunkt der Kontaktiermittel, d. h. der Klammern. Dieser Punkt ist für alle Klammern der Anlage an derselben Einlaufstelle. Die endlos umlaufenden Klammern werden vom Steuerungssystem am Greifpunkt so gesteuert, daß die Klammer bei vorhandener Leiterplatte an diesem Punkt im galvanotechnischen Sinne niedrigohmig auf das Kathodenpotential geschaltet wird und gleichzeitig die Platte ergreift. Befindet sich keine einlaufende Leiterplatte an diesem Punkt, so wird das Kathodenpotential nicht an die dort momentan befindliche Klammer angelegt. Zugleich wird das Schließen der Klammer verhindert. Dieser Zustand bleibt während des Durchlaufes der Klammer durch das Metallisierungsabteil erhalten. Der Vorgang wiederholt sich fortlaufend von Klammer zu Klammer.

Dieses Verfahren stellt sicher, daß eine Klammer nur dann niedrigohmig kathodisches Potential erhält, wenn sie es zum Galvanisieren des Behandlungsgutes benötigt. Fehlstellen in der Isolierschicht der Klammern oder im Bereich des metallischen Kontaktes zur Leiterplatte wirken dann nicht konzentrierend auf die Feldlinien. Diese Stellen galvanisieren nur so dick wie auch das Behandlungsgut. Für derartige Metallisierungen ist die vorhandene Entmetallisierung ausreichend wirksam. Wird eine Klammer gerade nicht benötigt, so wird die Schleifbürste der Klammer im Greifpunkt auch nicht an das Kathodenpotential angelegt. Die Klammer befindet sich jedoch örtlich mit dem metallisch blanken Kontakt im Elektrolyten zwischen den beiden positiven Anoden. Wegen des fehlenden niedrigohmigen Kathodenpotentiales nimmt jetzt die isoliert im Elektrolyten befindliche metallische Klammer über die offenen Kontakte und über den Elektrolyten im galvanotechnischen Sinne ein hochohmiges Potential an, das unterhalb des Kathodenpotentiales liegt. Dies bedeutet, daß die abgeschaltete Klammer hochohmig an einer niedrigeren Anoden- / Kathodenspannung liegt, als niedrigohmig zugeschaltete Klammern. Beides zusammen bewirkt, daß abgeschaltete Klammern gegenüber den kathodisch niederohmig kontaktierten Klammern und Leiterplatten leicht anodisch wirken und keinen galvanisierenden Badstrom aufnehmen. Eine elektrolytische Metallabscheidung findet damit auf Fehlstellen der Isolierschicht und an den Kontakten dieser Klammern während des Durchlaufes durch das Metallisierungsabteil nicht statt.

Zum elektrolytischen Behandeln werden in den bekannten Galvanoanlagen Gleichströme bis zu einigen kA verwendet. Niederohmige Widerstände im galvanotechnischen Sinne liegen deshalb im Bereich von unter einem Milliohm. Hochohmige Widerstände beginnen bereits unterhalb von einem Ohm.
Das erfindungsgemäße gezielte Zu- und Abschalten der Klammern erfolgt mittels der nachfolgend beschriebenen Vorrichtung:
Die Schleifbürste ist an der Klammer an einem beweglichen Bügel befestigt. Eine Feder drückt diesen Bügel in seine Schleifposition, das heißt in Richtung zur Schleifschiene. Am Einlaufumkehrpunkt wird die an dem endlos umlaufenden Transportband befestigte Klammer geöffnet. Dies geschieht mittels einer schiefen Ebene und einem darauf auflaufenden Gleitschuh, der an der Klammer befestigt ist. Gleichzeitig wird die Hubbewegung genutzt, um den Bügel gegen seinen Federdruck und über seine Schleifposition hinaus anzuheben. Wird die Klammer wegen eines vorhandenen Behandlungsgutes im Klammergreifpunkt benötigt, so schließt die Klammer beim Ablaufen von der schiefen Ebene. Zugleich geht der Bügel in seine Schleifposition. Wird vom Steuerungssystem ermittelt, daß kein Behandlungsgut am Klammergreifpunkt ankommt, so soll die Klammer nicht schließen und der Bügel soll mit seiner Schleifbürste nicht in die Schleifposition gehen. In diesem Falle sorgt eine vom Steuerungssystem beeinflußbare Sperre dafür, daß die Klammer trotz eines von der schiefen Ebene ablaufendem Gleitschuhes nicht schließt. Zugleich verhindert die Sperre, daß der Bügel die Schleifposition erreicht. Die Kraft für das Öffnen und Schließen der Klammern sowie das Abheben des Bügels gegen die Federkräfte wird vom leistungsstarken Klammerantrieb mittels Gleitschuh und schiefer Ebene oder durch andere, gleitende formschlüssige Verbindungen, wie zum Beispiel durch eine Kulissensteuerung, erzeugt. Die gesteuerte Sperre benötigt dagegen nur minimale Kräfte zu ihrer Bewegung. Deshalb eignet sich hier der Einsatz von Hilfsenergie, wie zum Beispiel Druckluft.

Die Sperre besteht aus einem beweglichen Teil, das zwei Zustände annimmt, nämlich "Klammer geöffnet und Bügel nicht in Schleifposition" sowie "Klammer geschlossen und Schleifbürste in Schleifposition". Zur Einnahme dieser Zustände dienen Geräte bzw. Kräfte, die vom Steuerungssystem beeinflußbar, d. h. schaltbar sind. Hierzu gehören Elektromagnete und Druckluftdüsen. Einseitig können auf die Sperre auch eine Federkraft oder die Schwerkraft einwirken. Es ist auch möglich, mit Hilfe einer Schaltfahne die Sperre berührend zu betätigen. Die Sperre ist so gestaltet, daß sie im geöffneten Zustand der Klammer leichtgängig die beiden Schaltzustände einnehmen kann. In einem Schaltpunkt blockiert die Sperre die Klammerschließbewegung. Die beiden federkraftbetriebenen Klammerteile stützen sich auf die Sperre ab. Zum Offenhalten wird keine weitere Energie benötigt. Im anderen Schaltpunkt der Sperre schließt die Klammer ungehindert.

In einer erfindungsgemäßen Ausführung der Vorrichtung besteht die Sperre aus einer aufrechtstehenden und beweglichen Klinke. Die Klinke wird durch ein Gewicht in der Schließposition gehalten. Jede Klammer schließt ohne weitere Betätigungen. Soll eine Klammer geöffnet bleiben, so wird die leichtgängige Klinke gegen die Schwerkraft während des Vorbeibewegens an einer Luftdüse mittels Druckluft in die Blockadeposition bewegt. Die Druckluft wird zum Beispiel mittels Magnetventil geschaltet. Der Ort der Lufteinwirkung auf die Klinke sowie die Dauer der Luftströmung je Schaltung sind im Bezug zur schiefen Ebene so abgestimmt, daß sich die Klammerteile auf der Klinke sicher abstützen können. Somit wird das Schließen verhindert. Die Erfindung wird anhand der nachfolgenden, im wesentlichen schematischen Zeichnungen weiter erläutert.
- Figur 1: zeigt in der Draufsicht eine horizontale Durchlaufanlage nach dem Stand der Technik;
- Figur 2: zeigt die Durchlaufanlage gemäß Fig. 1 mit erfindungsgemäß abgeschalteten Klammern in den Lücken zwischen Leiterplatten;
- Figur 3: zeigt das Zusammenwirken von Sensoren und Aktoren zur Steuerung der Sperre auf den Klammern;
- Figur 4: zeigt in der Draufsicht den Bereich der Leiterplatten, der von den Klammern nicht gegriffen werden soll, sowie das Greifen einer Leiterplatte in der Seitenansicht;
- Figur 5: zeigt eine Klammer in den drei wesentlichen Schaltzuständen, nämlich geschlossen, geöffnet mit freier Klinke, geöffnet mit eingerasteter Klinke;
- Figur 6: zeigt eine Klammer gemäß der Erfindung in perspektivischer Darstellungeiner realen Bauform;

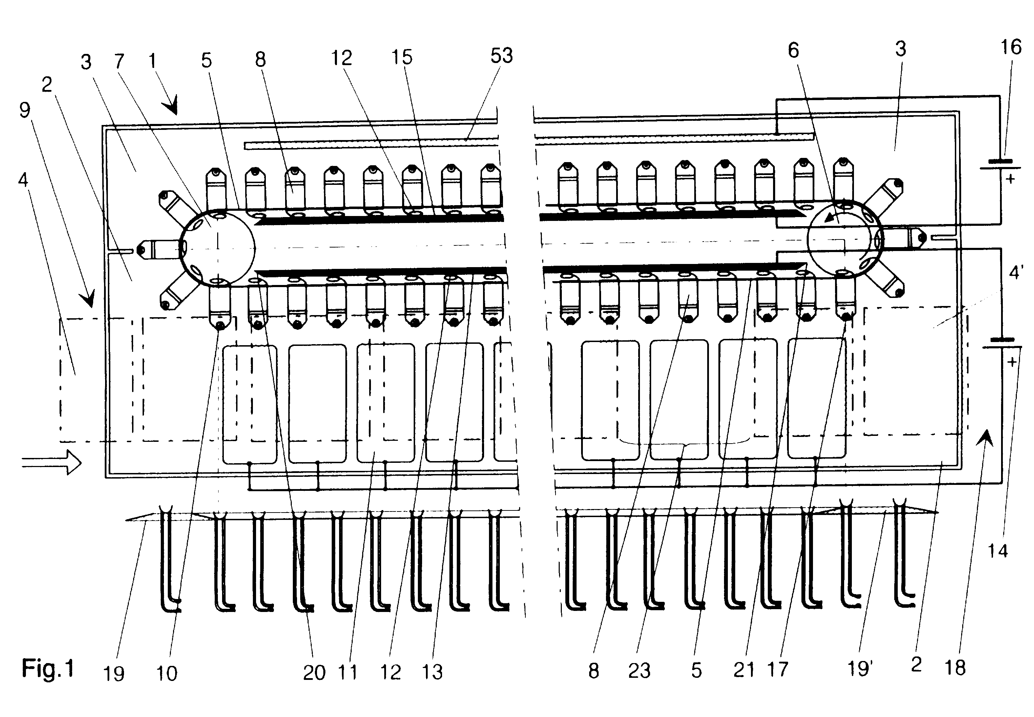

Figur 1 zeigt die Galvanoanlage 1. Diese ist unterteilt in das Metallisierungsabteil 2 und in das Entmetallisierungsabteil 3. Das einlaufende plattenförmige Behandlungsgut, zum Beispiel Leiterplatten, ist mit der Ziffer 4, das auslaufende Behandlungsgut ist mit 4' bezeichnet. Ein umlaufendes endloses Transportband 5, zum Beispiel ein Zahnriemen, wird vom Antriebsrad und Umlenkrad 6 in eine Richtung angetrieben und vom Umlenkrad 7 in die andere Richtung umgelenkt. An dem Transportband 5 sind in gleichmäßigen Abständen von z. B. 80 mm Kontaktiermittel in Form von Klammern 8 befestigt. Die Klammern ergreifen nach dem Einlauf 9 der Leiterplatten 4 in die Galvanoanlage 1 im Greifpunkt 10 nacheinander diese Platten 4 an ihrem Rand. Sie werden zwischen den ober- und unterseitigen Anoden 11, die löslich oder unlöslich sein können, horizontal durch die Anlage gefördert. An jeder Klammer 8 ist eine Schleifbürste 12 befestigt, die im Metallisierungsabteil über die erste Schleifschiene 13 eine gleitende elektrische Verbindung zum Minuspol der Galvanisierstromquelle 14 herstellt. Der Pluspol dieser Galvanisierstromquelle 14 ist elektrisch mit den Anoden 11 verbunden. Im Entmetallisierungsabteil 3 stellen die Schleifbürsten 12 der Klammern 8 über die zweite Schleifschiene 15 eine elektrische Verbindung zur Entmetallisierungsstromquelle 16 her. Am Offnungspunkt 17 geben die Klammern 8 die Leiterplatten 4' wieder frei. Sie verlassen rollengeführt am Auslauf 18 die Galvanoanlage 1. Das Schließen und Öffnen der Klammern wird durch Ablaufen bzw. Auflaufen derselben auf schiefen Ebenen 19 und 19' bewirkt. Die schiefen Ebenen befinden sich entlang der Transportbahn. Sie reichen bis in die Umlenkungen 6, 7 hinein. Im unteren Teil der Figur 1 ist die Lage der schiefen Ebenen in Bezug zum Greifpunkt 10 und zum Öffnungspunkt 17 dargestellt. Im Einlaufbereich befindet sich die schiefe Ebene 19 und im Auslaufbereich 19'. Auf der schiefen Ebene läuft eine Hälfte der Klammer 8 auf. Dabei öffnet sich die Klammer gegen die Schließkraft der Klammerfeder. Am Greifpunkt 10 ist die Klammer wieder geschlossen, unabhängig davon, ob sich eine Leiterplatte am Greifpunkt 10 befindet oder nicht. Desgleichen erfolgt danach am Kontaktierungspunkt 20 der Schleifschiene der Schleifbürste auch die elektrische Verbindung zur Galvanisierstromquelle 14. Nach dem Durchlauf der Klammer 8 durch die Galvanoanlage 1 wird die Klammer durch Auflaufen auf die schiefe Ebene 19' wieder geöffnet. Im Öffnungspunkt 17 wird die Leiterplatte 4' wieder freigegeben, sofern sich überhaupt eine Platte in der Klammer befand. Zuvor wurde am Ende der Schleifschiene, dem Kontaktöffnungspunkt 21 das elektrische Potential von der Klammer abgeschaltet.

Das Entmetallisierungsabteil 3 durchfahren die Klammern 8 im Beispiel der Figur 1 entsprechend dem Stand der Technik in geschlossenem Zustand. Als Ablagerungskathode wirken Bleche 22, die mit der Entmetallisierungsstromquelle 16 elektrisch verbunden sind. Das Problem einer derartigen Galvanisieranlage ist das eingangs beschriebene Metallisieren der Klammern. Trotz massiver elektrolytischer Entmetallisierung im Entmetallisierungsabteil 3 gelingt es nicht immer, alle metallischen Abscheidungen wieder zu entfernen. Deshalb wird auch versucht, die Klammern geöffnet durch das Entmetallisierungsabteil zu transportieren, damit die Metallabscheidungen an den die Leiterplatten fassenden Kontakten für die Feldlinien zugänglicher werden. Die geöffnete Klammer ist ebenfalls über die Schleifbürste 12 mit der Entmetallisierungsstromquelle 16 elektrisch verbunden. Zur Klammeröffnung im Entmetallisierungsabteil 3 wird das obere Niveau der schiefen Ebene 19' vom Auslaufbereich der Galvanoanlage bis zum Einlaufbereich derselben verlängert. Auch diese Maßnahme bringt keine entscheidende Verbesserung. Sie hat außerdem den Nachteil, daß sich die Reibung jeder Klammer auf der schiefen Ebene durch die gesamte Anlage bis zum Einlauf fortsetzt. Die Folge hiervon ist eine Schwergängigkeit des Antriebes, verbunden mit erhöhtem Abrieb der Nocken.

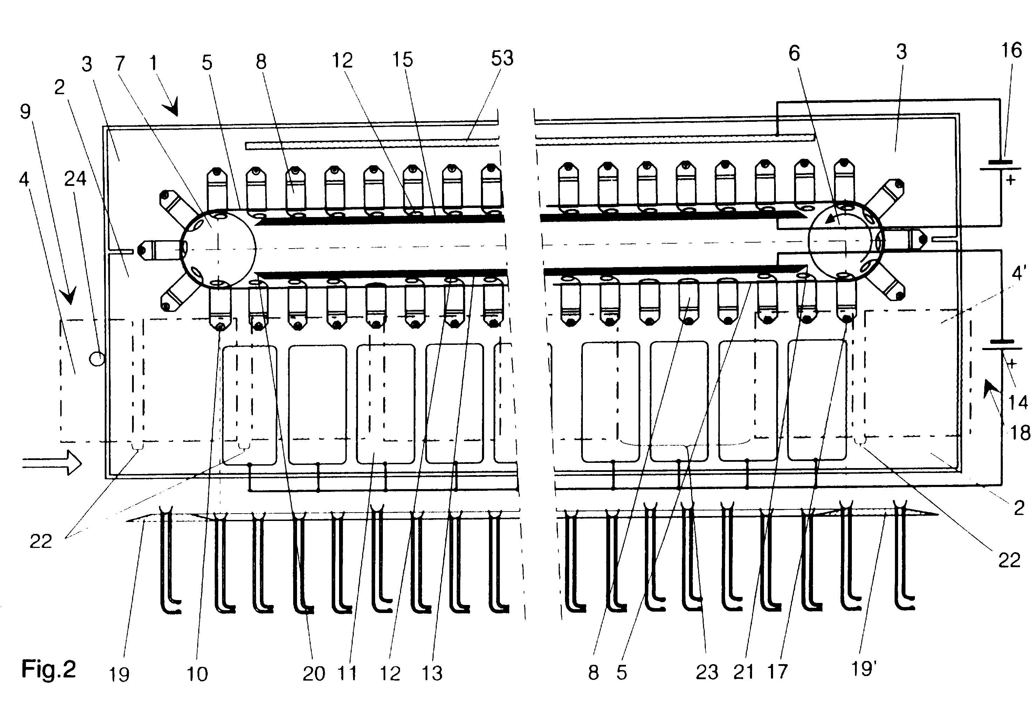

Die Figur 2 zeigt eine horizontale Durchlaufanlage entsprechend der Figur 1, jedoch mit erfindungsgemäß geöffneten und abgeschalteten Klammern. Soweit Teile identisch oder wirkungsgleich sind, werden damit übereinstimmende Bezugsziffern der Figur 1 wieder verwendet. Die Leiterplatten 4 werden nacheinander am Einlauf 9 in die Galvanoanlage 1 eingefahren. In dieser Einfahrfolge sind zwischen den einzelnen Leiterplatten Abstände eingezeichnet. Zwischen jeder Leiterplatte besteht aus transporttechnischen und galvanotechnischen Gründen ein Leiterplatten-Normalabstand 22. Bei fehlendem Behandlungsgut entstehen Leiterplattenlücken 23. Die Leiterplatten 4 haben in der Praxis mindestens in Transportrichtung unterschiedliche Längen und die Beschickung der Anlage erfolgt zu beliebigen Zeitpunkten. Deshalb ist eine Synchronisation des Klammerantriebes mit der Behandlungsgutfolge nicht möglich. Klammern 8 sind somit auch zwischen den Leiterplatten 4, das heißt in den Abständen 22 und in den Lücken 23positioniert. Die Klammern 8 in den Bereichen 22 und 23 bleiben erfindungsgemäß geöffnet und elektrisch abgeschaltet. Die Klammeröffnung ist im unteren Teil der Figur 2 dargestellt, die Klammerabschaltung vom Kathodenpotential wird durch in der Zeichnung fehlende Schleifbürsten 12 an den betreffenden Klammern dargestellt.

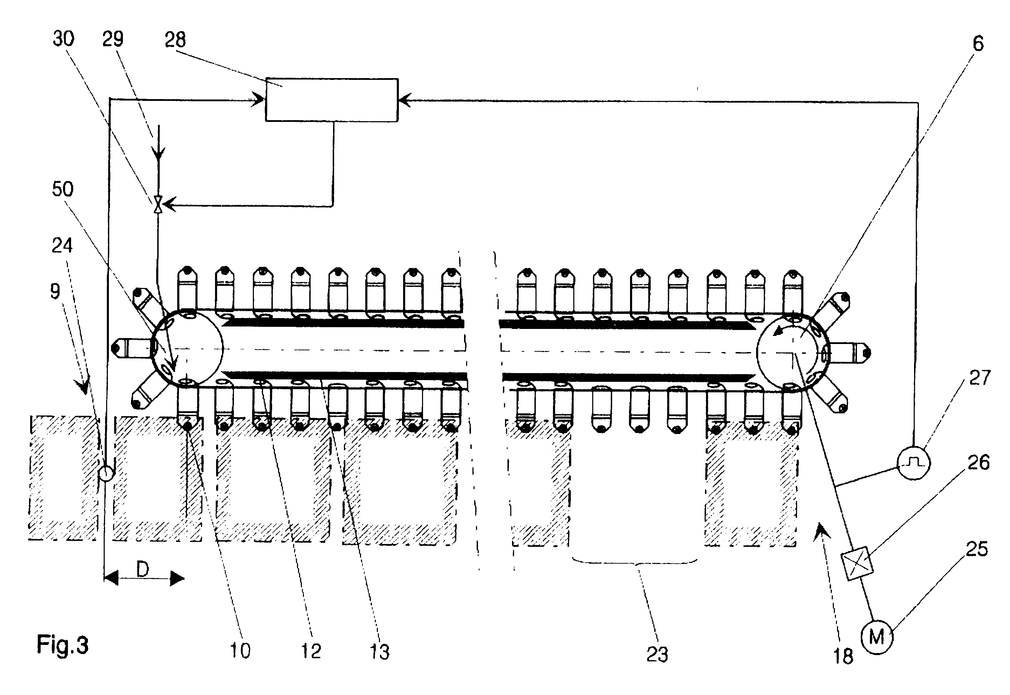

Die Figur 3 zeigt die zur Klammerabschaltung erforderlichen Komponenten. Ein Leiterplattensensor 24 im Einlaufbereich der Galvanoanlage, z. B. eine Lichtschranke, detektiert die Länge jeder Leiterplatte. Dies bedeutet zugleich, daß er die Leiterplatten-Normalabstände 22 und die Leiterplattenlücken 23 erfaßt. Der Motor 25 treibt über das Getriebe 26 und das Antriebsrad 6 die Klammern an. Diese Einheiten werden gemeinsam kurz als Klammerantrieb bezeichnet. Der Motor 25 treibt auch synchron die nicht dargestellten Transportrollen am Einlauf 9 und am Auslauf 18 der Galvanoanlage an. Die Leiterplatten-Transportgeschwindigkeit richtet sich im wesentlichen nach der erforderlichen Behandlungszeit der Leiterplatten in der Galvanoanlage. Sie liegt in der Praxis bei 0,5 bis 3 Meter pro Minute. Die aktuelle Transportgeschwindigkeit mißt ein weiterer Sensor. Im Beispiel der Figur 3 ist es ein incrementaler Weggeber 27. Er gibt beispielsweise je Millimeter Leiterplatten-Transportweg einen Impuls ab. Diese Weggeberkonstante wird im Steuerungssystem 28 als Parameter hinterlegt. Das Steuerungssystem ist zum Beispiel eine für sich bekannt speicherprogrammierbare Steuerung, handelsüblich auch SPS benannt. Die momentanen Signale der Sensoren 24 und 27 erfaßt das Steuerungssystem 28 fortlaufend. Als weiterer Parameter ist die Distanz D hinterlegt. Die Distanz D ist der konstante Abstand der vom Leiterplattensensor 24 detektierten Leiterplattenkanten vom Greifpunkt 10 der Klammern. Die beiden Parameter dienen zur Berechnung, wieviele Impulse des incrementalen Weggebers 27 in das Steuerungssystem 28 einlaufen müssen, bis eine vom Leiterplattensensor 24 detektierte Leiterplattenkante am Greifpunkt 10 angekommen ist. Dies gilt sowohl für die ansteigende Flanke, z. B. für den Beginn einer Leiterplatte, wie auch für die abfallende Flanke. Bei einem Transportweg von 1 mm pro Impuls ist die Anzahl der Impulse gleich der Distanz D in Millimetern. Mit Kenntnis der Leiterplattensituation am Greifpunkt 10 steuert das Steuerungssystem 28 eine Sperre, die sich auf jeder Klammer befindet. Als Steuerungsenergie dient beispielsweise Druckluft 29, die durch das von der SPS angesteuerte Magnetventil 30 geschaltet wird. Die Sperre gibt in einem Schaltzustand die Klammer zum Schließen frei oder sie blokkiert sie im anderen Schaltzustand. Im blockierten Zustand wird zugleich ein Aufsetzen der Schleifbürste 12 auf die Schleifschiene 13 verhindert.

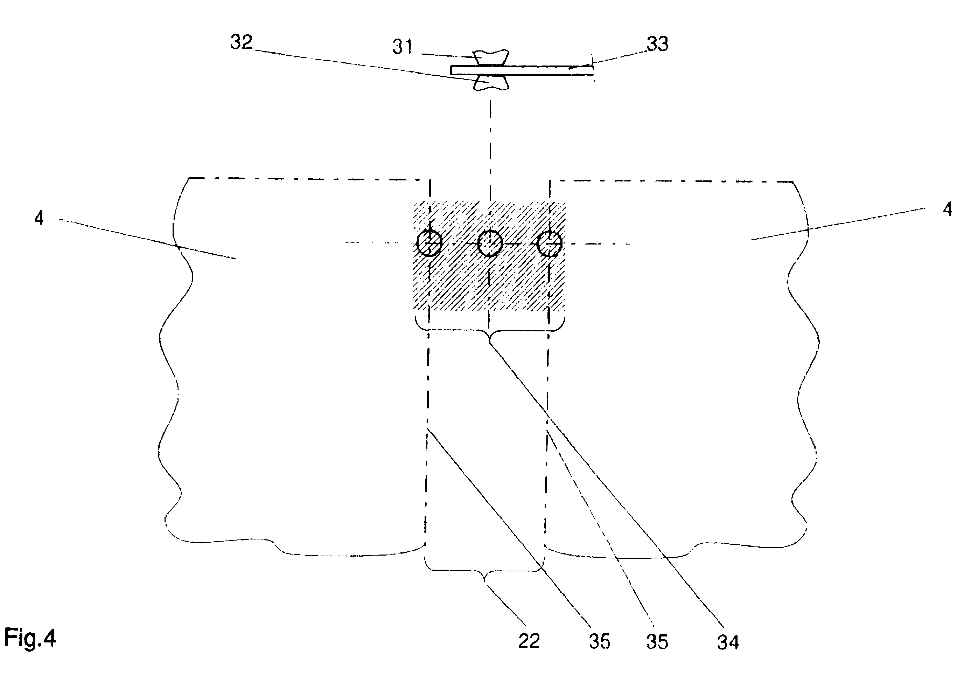

Die Figur 4 zeigt vergrößert die Situation an einem Leiterplatten-Normalabstand 22 in der Draufsicht sowie die Klammerkontakte in der Seitenansicht. Der Abstand zwischen zwei Leiterplatten 4 variiert in der Praxis zwischen etwa 0 und 30 Millimetern. Das Klammeroberteil hat den oberen Klammerkontakt 31 und das Unterteil den unteren Klammerkontakt 32. Diese greifen die Leiterplatte 33. Im schraffiert dargestellten Bereich 34 soll die Klammer nicht geschlossen werden. Nur wenn die Kontakte 31 und 32 voll auf der Leiterplatte 4, 33 aufsitzen, sollen sie schließen. Der Bereich 34 wird so gewählt, daß auch Toleranzen nicht zu Fehlgriffen führen. Damit wird auch sichergestellt, daß an der Leiterplattenkante 35 kein Kontakt angreift. Er könnte eine einlaufende Leiterplatte 4 aus ihrer ausgerichteten Position auf der Transportbahn verschieben. Das Verschieben kann einen Leiterplattenstau verursachen.

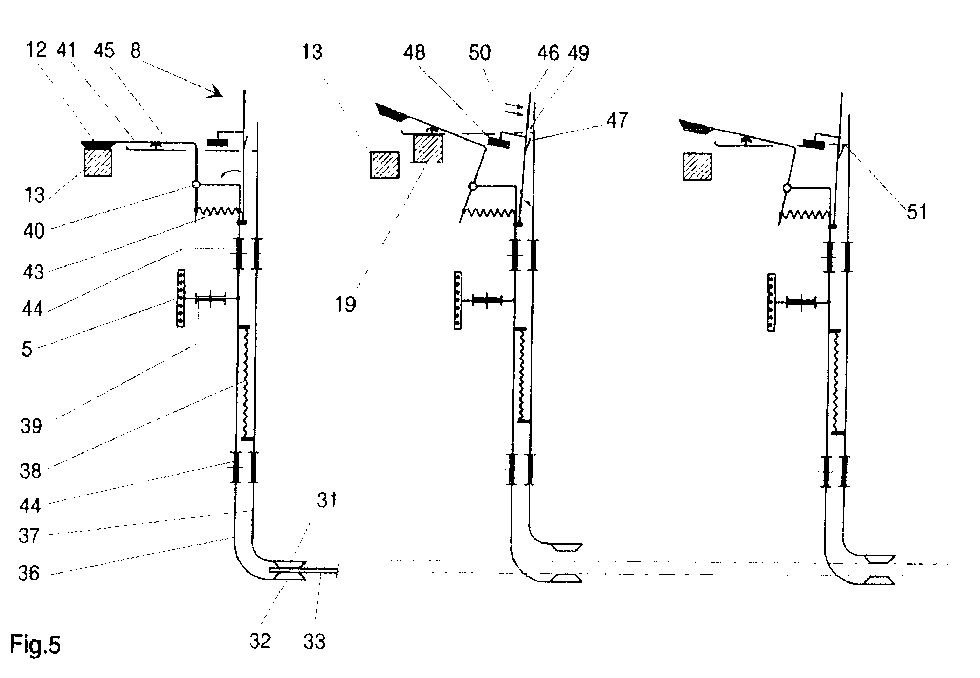

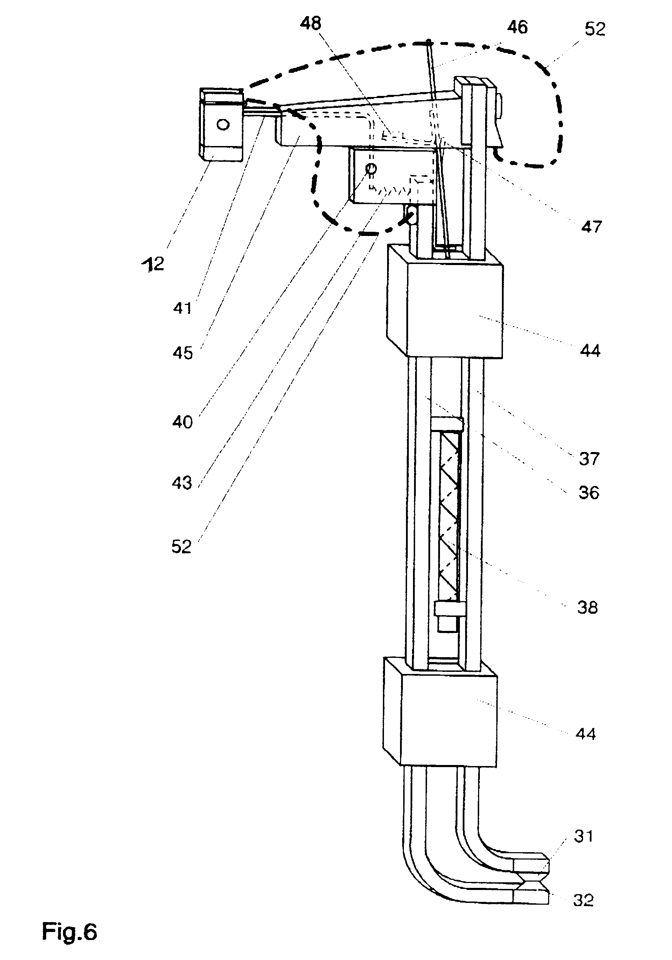

Am Beispiel der Figur 5 sollen die Schaltzustände der Klammer erläutert werden. Die Klammer 8 besteht aus dem Klammerunterteil 36 und dem Klammeroberteil 37. Eine Druckfeder 38 drückt die Kontakte 31 und 32 beider Teile aufeinander. Daraus resultiert die Schließkraft der Klammer. Das Klammerunterteil 36 wird von einer Gleitführung 39 geführt, und es ist am endlos umlaufenden Transportband 5 befestigt. Am Teil 36 befindet sich eine Lagerstelle 40 für den Bügel 41, der die Schleifbürste 12 trägt. Zur sicheren elektrischen Stromübertragung ist die Schleifbürste mittels Hochstromlitzen 52 (Fig. 6) mit den Klammerteilen 36 und 37 verbunden. Der Kontaktbügel 41, die Lagerstelle 40 sowie die Zugfeder 43 übernehmen dann nur noch mechanische Funktionen. Die als Beispiel dargestellte Zugfeder 43 bewirkt die Schleifkontaktkraft zur Schleifschiene 13. Führungen 44 ermöglichen das vertikale Verschieben des Klammeroberteils 37 im Bezug zum Klammerunterteil 36. Der Antrieb hierfür wird über einen Gleitschuh 45, der auf der schiefen Ebene 19 aufläuft, eingeleitet. Damit hebt die Schleifbürste 12 von der Schleifschiene 13 ab, so wie es im mittleren Teil der Figur 5 dargestellt ist. Zugleich öffnet die Klammer im Bereich ihrer Kontakte 31, 32. Auf dem Klammerunterteil 36 steht eine bewegliche Sperre in Form einer Klinke 46 mit einer Ausstellung 47. Das Gewicht 48 hält die Klinke, die durch den Gleitschuh 45 hindurchragt, an ihrem linken Anschlag. Die Öffnung 49 ist so groß, daß sich bei links angeschlagener Klinke 46 das Klammeroberteil 37 von der schiefen Ebene 19 angetrieben auf und ab bewegen kann. Wird die Klinke von einem Luftstrom 50 aus der eingezeichneten Richtung angeströmt, so bewegt sie sich gegen die Schwerkraft des Gewichtes 48 nach rechts. Beim gleichzeitigen Absenken des Klammeroberteiles 37 rastet die Ausstellung 47 der Klinke 46 im Bereich 51 am Gleitschuh 45 ein. Die Klammer 8 ist blockiert. So wie in Figur 5 rechts dargestellt bleibt sie offen, auch wenn die schiefe Ebene am Gleitschuh 45 nicht mehr angreift. Wird der Gleitschuh 45 ohne Luftstrom 50 wieder von der schiefen Ebene angehoben, so fällt die Klinke 46 zurück. Beim darauffolgenden Absenken schließt die Klammer wieder.

Die Abläufe der Figur 5 sind nur ein Beispiel der Erfindung. So lassen sich die Funktionen auch umkehren. Der Luftstrom an die Klinke bewirkt die Klammerschließung, und die Schwerkraft des Gewichtes wird zum Einrasten genutzt. Das Gewicht der Klinke kann auch durch eine Federkraft ersetzt werden. Auch die berührende Betätigung der Sperre ist möglich.

Die Figur 6 zeigt ein praktisches Ausführungsbeispiel einer Klammer 8, so wie sie in einer Galvanoanlage verwendet werden soll und deren Bezugsziffern und Beschreibung den Schemata gemäß den Fig. 1 - 5 entspricht.

## Patentansprüche

1. Verfahren zum Galvanisieren von plattenförmigem Behandlungsgut, insbesondere von Leiterplatten und Leiterfolien, in horizontalen Durchlaufanlagen mit beliebiger Behandlungsgutfolge, wobei umlaufende Kontaktiermittel zur elektrischen Verbindung einer Badstromquelle über Schleifschienen mit dem Behandlungsgut dienen, dadurch gekennzeichnet, daß mit Hilfe von Sensoren Anfang und Ende jedes einzelnen Behandlungsgutes am Einlauf der Galvanisieranlage und die Transportgeschwindigkeit des Behandlungsgutes ermittelt werden, die Sensoren Sensorsignale einem Steuerungssystem zuführen, welches feststellt, ob im Greifpunkt (10) das Kontaktiermittel Behandlungsgut vorfindet oder nicht, wobei das Kontaktiermittel nur dann mit den Badstromquellen elektrisch und im galvanotechnischen Sinne niederohmig verbunden wird, wenn sich in dem Bereich von Kontakten (31, 32) der Kontaktiermittel Behandlungsgut befindet.

2. Verfahren nach Anspruch 1, dadurch gekennzeichnet, daß sich das Kontaktiermittel zum Ergreifen des Behandlungsgutes nur dann schließt, wenn sich im Bereich der Kontakte (31, 32) Behandlungsgut befindet.

3. Verfahren nach Anspruch 1 oder 2 dadurch gekennzeichnet, daß das Steuerungssystem in Abhängigkeit vom Vorhandensein des Behandlungsgutes eine Schließ-Sperre in der Klammer (8) durch Ansteuerung betätigt.

4. Verfahren nach Anspruch 3, dadurch gekennzeichnet, daß Kräfte zum Öffnen der Klammern (8) gegen die Federschließkräfte vom Klammerantrieb abgeleitet werden und nur zur Steuerung der Sperre Hilfsenergie verwendet wird.

5. Verfahren nach einem der Ansprüche 3 und 4, dadurch gekennzeichnet, daß das Kontaktiermittel durch die eingerastete Sperre ohne Hilfsenergie und ohne weiteren Antriebskraftaufwand offen gehalten wird.

6. Verfahren nach einem der Ansprüche 1 bis 5, dadurch gekennzeichnet, daß die Kräfte zum Bewegen der Kontaktiermittel über schiefe Ebenen und dafür ausgebildeten Gleitschuhe oder über gleitende formschlüssige Verbindungen eingeleitet werden.

7. Verfahren nach einem der Ansprüche 1 bis 6, dadurch gekennzeichnet, daß durch Unterbrechen der niederohmigen elektrischen Verbindung des Kontaktiermittels mit der Badstromquelle das Kontaktiermittel in dem Metallisierungsabteil ein galvanotechnisch hochohmiges und gegenüber den nicht unterbrochenen Kontaktiermitteln niedrigeres Anoden- / Kathodenpotential zur Vermeidung einer elektrolytischen Abscheidung von Metall auf dem Kontaktiermittel, auch wenn dieses metallisch blanke Stellen aufweist, eingestellt wird.

8. Vorrichtung zum Galvanisieren von plattenförmigem Behandlungsgut, insbesondere von Leiterplatten und Leiterfolien, in horizontalen Durchlaufanlagen mit an einem Transportband befestigten, gezogenen bzw. geschobenen, außerhalb des Kontaktierbereiches mit einer Isolierschicht versehenen Kontaktiermitteln für das Behandlungsgut, die endlos umlaufen und zum Öffnen und Schließen auf schiefen Ebenen auf- und ablaufen, insbesondere zur Realisierung des Verfahrens nach den Ansprüchen 1 bis 7, gekennzeichnet durch
- Sensoren (24) am Einlauf (9) der Galvanoanlage (1),
- ein Steuerungssystem zur logischen Verknüpfung von Sensorsignalen der Sensoren,
- eine zweiteilige Klammer (8) zur Aufnahme des Behandlungsgutes (4, 33), umfassend im wesentlichen
- eine Feder (38), die ein Klammerunterteil (36) gegen ein Klammeroberteil (37) drückt, so daß deren Kontaktbereiche (31, 32) das Behandlungsgut elektrisch kontaktieren und mechanisch halten,
- eine bewegliche Klinke (46) an der Klammer zur Freigabe des Schließens der Klammer (8) oder zur Blockade im geöffneten Zustand,
- einen gesteuerten Antrieb für die Bewegung der Klinke (46) in eine Schließstellung und in eine Blockadestellung der Klammer (8),
- einen Gleitschuh (45) mit Hebelübersetzung auf einen in einer Lagerstelle (40) drehbar gelagerten Bügel (41) mit einer Schleifbürste (12) zum Abheben der Schleifbürste von einer Schleifschiene (13) im geöffneten Zustand der Klammer (8).

9. Vorrichtung nach Anspruch 8, dadurch gekennzeichnet, daß zur Blockade der Klammer die Klinke (46) mit einer Ausstellung (47) versehen ist, die in den Gleitschuh (45) einrastet.

10. Vorrichtung nach einem der Ansprüche 8 oder 9, gekennzeichnet durch einen gesteuerten Antrieb der Klinke (46) mittels Druckluft, Schwerkraft, Federkraft, Magnetkraft oder Formschluß zur Bewegung derselben in die Schließstellung und in die Blockadestellung der Klammer (8).

11. Vorrichtung nach einem der Ansprüche 8 bis 10, gekennzeichnet durch elektrische Verbindungen von der Schleifbürste (12) zu den Klammerhälften (36, 37) in Form von flexiblen elektrischen Leitern (52).

12. Vorrichtung nach einem der Ansprüche 8 bis 11, gekennzeichnet durch eine Länge des obersten Niveaus der schiefen Ebenen (19), die zur Vermeidung von unnötig lang andauernden Reibkräften so gewählt wird, wie sie zum Steuern der Klinke (46) gerade noch ausreicht.

## Claims

1. Method of electroplating plate-like articles to be treated, more especially printed circuit boards and conductor foils in horizontal, continuously operating systems with any desirable sequence of articles to be treated, rotatable contacting means being used for the electrical connection of a source of bath current, via sliding contacts, to the article to be treated, characterised in that the beginning and the end of each individual article to be treated at the inlet of the electroplating system and the speed of conveyance of the article to be treated are determined by means of sensors, and the sensors supply sensor signals to a control system which ascertains whether or not there is article to be treated at the pick-up point (10) of the contacting means, the contacting means being connected electrically, and with low-impedance in the electroplating sense, to the sources of bath current only when there is article to be treated in the region of contacts (31, 32) of the contacting means.

2. Method according to claim 1, characterised in that the contacting means for gripping the article to be treated only closes when there is article to be treated in the region of the contacts (31, 32).

3. Method according to claim 1 or 2, characterised in that the control system actuates a shut-off closing means in the clip (8) by actuation depending on whether the article to be treated is present.

4. Method according to claim 3, characterised in that forces for opening the clips (8) in opposition to the resilient closing forces are derived from the clip drive, and auxiliary energy is only used to control the shut-off means.

5. Method according to one of claims 3 and 4, characterised in that the contacting means is kept open by the locked shut-off means without auxiliary energy and without a further consumption of driving forces.

6. Method according to one of claims 1 to 5, characterised in that the forces for moving the contacting means are introduced via inclined planes and guide shoes provided therefor or via sliding, form-locking connections.

7. Method according to one of claims 1 to 6, characterised in that, by interrupting the low-impedance electrical connection between the contacting means and the source of bath current, the contacting means in the metallization section is set an anode/cathode potential, which is high-impedance in the electroplating sense and is lower than the uninterrupted contacting means, to prevent an electrolytic deposition of metal on the contacting means, even when said means has metallically bright locations.

8. Apparatus for electroplating plate-like article to be treated, more especially printed circuit boards and conductor foils in horizontal, continuously operating systems with pulled or pushed contacting means for the material to be treated, which contacting means are mounted on a conveyor belt and are provided with an insulating layer externally of the contacting region, said means rotating continuously and travelling upwardly and downwardly inclined planes for opening and closing purposes, more especially for accomplishing the method according to claims 1 to 7, characterised by
- sensors (24) at the inlet (9) of the electroplating system (1),
- a control system for the logic combination of sensor signals of the sensors, and
- a two-part clip (8) for accommodating the articles to be treated (4, 33), substantially comprising
- a spring (38), which urges a lower clip portion (36) towards an upper clip portion (37), so that their contact regions (31, 32) electrically contact and mechanically retain the article to be treated,
- a displaceable pawl (46) on the clip to release the closure of the clip (8) or to block the clip in the opened state,
- a controlled drive for moving the pawl (46) in order to produce a closed position and a blocked position for the clip (8), and
- a guide shoe (45) with lever transmission to a clamp (41), which is rotatably mounted in a mounting location (40) and has a sliding brush (12), for lifting the sliding brush from a sliding contact (13) when the clip (8) is in its opened state/position.

9. Apparatus according to claim 8, characterised in that, in order to block the clip, the pawl (46) is provided with an extension (47), which locks into the guide shoe (45).

10. Apparatus according to one of claims 8 or 9, characterised by a controlled drive for the pawl (46) by means of compressed air, force of gravity, resilient force, magnetic form or form-locking to move said pawl into the closed position and into the blocked position for the clip (8).

11. Apparatus according to one of claims 8 to 10, characterised by electrical connections between the sliding brush (12) and the clip halves (36, 37) in the form of flexible electrical conductors (52).

12. Apparatus according to one of claims 8 to 11, characterised by a length for the uppermost level of the inclined planes (19), which length is so selected, in order to eliminate unnecessarily long-lasting frictional forces, that it is still sufficient to control the pawl (46).

## Revendications

1. Procédé de galvanisation de produits à traiter en forme de plaques, en particulier des plaquettes de circuits imprimés et des feuilles pour circuits imprimés, dans des installations à passage horizontal avec une série quelconque de produits à traiter, des éléments de contact étant destinés à établir, par l'intermédiaire de rails de frottement, la liaison électrique entre une source de courant pour le bain et le produit à traiter, caractérisé en ce que le début et la fin de chaque produit à traiter et la vitesse de transport du produit à traiter sont déterminés par des capteurs montés à l'entrée de l'installation de galvanisation, en ce que les capteurs envoient des signaux vers un système de commande qui détecte si le produit à traiter se trouve ou non au point de préhension (10) de l'élément de contact, l'élément de contact étant relié aux sources de courant pour le bain par voie électrique ou par basse impédance, dans le sens galvano-technique, à la seule condition que le produit à traiter se situe dans la zone des contacts (31, 32) de l'élément de contact.

2. Procédé selon la revendication 1, caractérisé en ce que l'élément de contact destiné à saisir le produit à traiter ne se ferme que si le produit à traiter se trouve dans la zone des contacts (31, 32).

3. Procédé selon la revendication 1 ou 2, caractérisé en ce que, en fonction de la présence du produit à traiter, le système de commande actionne par excitation un bloqueur de fermeture dans la pince (8).

4. Procédé selon la revendication 3, caractérisé en ce que des forces pour l'ouverture des pinces (8) sont déviées à l'encontre des forces de fermeture exercées par le ressort du moteur des pinces et en ce que seule la commande du bloqueur nécessite une énergie auxiliaire.

5. Procédé selon les revendications 3 et 4, caractérisé en ce que l'élément de contact est maintenu ouvert par le bloqueur encliqueté, sans énergie auxiliaire et sans autre déploiement de force motrice.

6. Procédé selon l'une quelconque des revendications 1 à 5, caractérisé en ce que les forces exercées pour déplacer l'élément de contact sont introduites par des plans inclinés et des patins de guidage conçus à cet effet ou par des assemblages coulissants à engagement claboté.

7. Procédé selon l'une quelconque des revendications 1 à 6, caractérisé en ce que, par interruption de la liaison électrique à faible impédance entre l'élément de contact et la source de courant pour le bain, l'élément de contact est régulé dans la section de métallisation avec un potentiel cathodique et/ou anodique à haute impédance sur le plan galvano-technique et à plus faible impédance par rapport aux éléments de contact non interrompus, de manière à empêcher une précipitation par électrolyse du métal sur l'élément de contact, même si celui-ci présente des surfaces sans métal.

8. Dispositif de galvanisation de produits à traiter en forme de plaques. en particulier des plaquettes de circuits imprimés et des feuilles pour circuits imprimés, dans des installations à passage horizontal comprenant des éléments de contact pour le produit à traiter, fixés, tirés ou poussés sur une bande transporteuse, munis d'une couche isolante en dehors de la zone de contact, qui tournent en continu et montent et descendent sur des surfaces inclinées pour s'ouvrir et se fermer, en particulier pour la mise en oeuvre du procédé selon les revendications 1 à 7, caractérisé par
- des capteurs (24) à l'entrée (9) du dispositif de galvanisation (1),
- un système de commande pour l'enchaînement logique des signaux émis par les capteurs,
- une pince (8), formée de deux parties et destinée à recevoir le produit à traiter (4, 33), comprenant sensiblement
- un ressort (38), qui pousse une partie inférieure de la pince (36) contre une partie supérieure de la pince (37), de telle sorte que ses zones de contact (31, 32) établissent un contact électrique avec le produit à traiter et le maintiennent mécaniquement,
- une lame mobile (46) sur la pince, destinée à libérer la fermeture de la pince (8) ou à la bloquer en position ouverte,
- un moteur commandé pour actionner la lame (46) dans une position de fermeture et dans une position de blocage de la pince (8),
- un patin de guidage (45), comprenant un levier démultiplié sur un étrier (41) monté de manière pivotante dans un logement (40) et un balai de frottement (12), destiné à soulever le balai de frottement pour le détacher d'un rail de frottement (13) lorsque la pince (8) est en position ouverte.

9. Dispositif selon la revendication 8, caractérisé en ce que, pour le blocage de la pince, la lame (46) est munie d'une partie en saillie (47) qui s'enclenche dans le patin de guidage (45).

10. Dispositif selon la revendication 8 ou 9, caractérisé par un moteur commandé par air comprimé, force centrifuge, poussée du ressort, force magnétique, destiné à la lame (46) ou par un clabot pour actionner cette dernière en position de fermeture ou en position de blocage de la pince (8).

11. Dispositif selon l'une quelconque des revendications 8 à 10, caractérisé par des liaisons électriques entre le balai de frottement (12) et les moitiés de pince (36, 37), sous forme de conducteurs électriques flexibles (52).

12. Dispositif selon l'une quelconque des revendications 8 à 11, caractérisé par une longueur du niveau supérieur des plans inclinés (19), qui est définie de manière à éviter des forces de frottement de durée inutilement longue, de telle sorte qu'elle suffit juste encore pour commander la lame (46).
